(19) Europäisches Patentamt / European Patent Office / Office européen des brevets

(11) **EP 3 139 705 A1**

(12) **EUROPEAN PATENT APPLICATION**
published in accordance with Art. 153(4) EPC

(43) Date of publication:
08.03.2017 Bulletin 2017/10

(51) Int Cl.:
*H05B 33/02* (2006.01)  *G02B 3/00* (2006.01)
*G02B 5/18* (2006.01)  *H01L 51/50* (2006.01)
*H05B 33/22* (2006.01)

(21) Application number: 15786779.7

(22) Date of filing: 24.04.2015

(86) International application number:
PCT/JP2015/062507

(87) International publication number:
WO 2015/166884 (05.11.2015 Gazette 2015/44)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA

(30) Priority: 28.04.2014 JP 2014093051

(71) Applicant: JX Nippon Oil & Energy Corporation
Chiyoda-ku,
Tokyo 100-8162 (JP)

(72) Inventors:
• NISHIMURA, Suzushi
Tokyo 100-8162 (JP)
• SHIBANUMA, Toshihiko
Tokyo 100-8162 (JP)
• TORIYAMA, Shigetaka
Tokyo 100-8162 (JP)

(74) Representative: Carpmaels & Ransford LLP
One Southampton Row
London WC1B 5HA (GB)

(54) **LIGHT EMITTER**

(57) Provided is a light-emitting element capable of taking out emitted light efficiently to outside and securing sufficient light-emitting area. The light-emitting element 10 includes translucent substrate 11 having first and second surfaces, concavo-convex layer 12 having a concavo-convex pattern, first electrode layer 12, organic luminescent layer 14 having a light-emitting part, second electrode layer 15, and lens member 16 having a diameter D1. The concavo-convex layer, the first electrode layer, the organic luminescent layer, and the second electrode layer form a laminate in this order on the first surface side of the substrate, with the concavo-convex pattern arranged on the first electrode layer side of the concavo-convex layer. The substrate is provided with the lens member on the second surface, and the light-emitting part is a laminated region of a diameter D2 of the organic luminescent layer held between the first and second electrode layers, and the center of the light-emitting part is aligned concentrically to the center of the lens member. The ratio of the diameter D2 of the light-emitting part to the diameter D1 of the lens member is 0.7 < D2/D1 ≤ 1.0.

Fig. 1

**Description**

The present invention relates to light-emitting elements used in displays, illuminating devices, taillights of vehicles, or the like.

There are known organic light-emitting diodes (OLED) employing organic electroluminescence (EL), which are light-emitting elements providing high contrast, suitable for thickness- and weight-saving, and usable in next-generation displays or illuminating devices. OLED has, on a transparent substrate, an anode, an organic light-emitting layer, and a cathode, laminated in this order and, when electric voltage is applied across the electrodes, holes and electrons are supplied to the organic light-emitting layer from the anode and the cathode, respectively, and the organic molecules are excited by recombination to emit light. For utilizing such emitted light in display devices or illuminating devices, technology needs to be developed for efficiently extracting the emitted light from the organic light-emitting layer to the element surface.

In Patent Publication 1, a problem in conventional organic EL elements, wherein the transparent substrate is provided with a convex part for each light-emitting unit to improve the efficiency of light extraction, that is, this convex structure cannot prevent total reflection at the interface between the substrate and air, is considered, and an organic luminescent element is proposed which does not employ the convex structure. Specifically, this publication proposes an organic luminescent element comprising a substrate, an organic EL element having a light-emitting section, and a lens, wherein an area of a face of the light-emitting section, parallel to the substrate's surface, is set to be smaller than an area of the substrate, on which the lens is attached, and wherein an angle between a line, perpendicular to the substrate's surface in a direction from the light-emitting section toward the substrate, and a straight line, connecting an end of the light-emitting section and an end of the lens, is set to be more than or equal to 60°.

Patent Publication 2 proposes an organic EL element comprising a substrate, and on its inner side, a diffraction grating which comprises a concavity and convexity layer, a transparent electrode, an organic layer having a light emitting layer, and a metal electrode which are stacked in this order, and a semispherical lens on the other side of the substrate, wherein the concavity and convexity layer has a particular structure.

In the organic EL element disclosed in this publication, the light emitting layer of the organic layer is patterned and the pattern is in rectangular forms, so that it is difficult to fully secure the area for light emission from the surface of the semispherical lens provided on the other side of the substrate, and further improvement in the light emitting efficiency is desired.

Patent Publication 1: JP-201μ54407-A
Patent Publication 2: JP-2013-127844-A

It is an object of the present invention to provide a light-emitting element that is capable of extracting the light emitted from the light-emitting part to outside at a high efficiency, and of securing a sufficient light-emitting area.

According to the present invention, there is provided a light-emitting element comprising a translucent substrate having opposing first and second surfaces, a concavo-convex layer having on one of its surfaces a concavo-convex pattern, a first electrode, an organic luminescent layer having a light-emitting part, a second electrode, and a lens member having a diameter D1,
wherein said concavo-convex layer, said first electrode layer, said organic luminescent layer, and said second electrode layer form a laminate in this order on a first surface side of said substrate, with said concavo-convex pattern arranged on a first electrode layer side of said concavo-convex layer,
wherein said substrate is provided with said lens member on said second surface,
wherein said light-emitting part is a laminated region of a diameter D2 of said organic luminescent layer held between said first and second electrode layers, and a center of said light-emitting part is aligned concentrically to a center of said lens member, and
wherein a ratio of the diameter D2 of the light-emitting part to the diameter D1 of the lens member is $0.7 < D2/D1 \leq 1.0$.

The light-emitting element according to the present invention, which includes the above-mentioned components, in particular, the lens member and the concavo-convex layer having the concavo-convex pattern, and wherein the ratio of the diameter D2 of the light-emitting part to the diameter D1 of the lens member is regulated within the particular range, is capable of taking out the light emitted from the light-emitting part efficiently to outside, and securing sufficiently large light-emitting area from the lens member. Thus, the light-emitting element of the present invention is usable in various light-emitting devices, such as next-generation displays providing high contrast and suitable for thickness- and weight-saving, illuminating devices, and luminescent display devices, such as taillights of vehicles. The light-emitting element of the present invention may also be useful in the production of various devices, such as organic EL elements having excellent heat resistance, weatherability, and corrosion resistance.

Fig. 1 (1a) is a schematic plan view of a light-emitting element according to an embodiment of the present invention, and Fig. 1 (1b) is a schematic sectional view of the element taken along lines I-I in Fig. 1 (1a).

Fig. 2 (2a) is a schematic plan view of a light-emitting element according to another embodiment of the present invention, and Fig. 2(2b) is a schematic sectional view of the element taken along lines I-I in Fig. 2(2a).

Fig. 3 (3a) is a schematic plan view of a light-emitting element according to still another embodiment of the present invention, and Fig. 3(3b) is a schematic sectional view of the element taken along lines I-I in Fig. (3a).

Fig. 4 (4a) is a schematic plan view of a light-emitting element according to still another embodiment of the present invention, and Fig. 4(4b) is a schematic sectional view of the element taken along lines I-I in Fig. 4(4b).

Fig. 5 is a schematic explanatory view for explaining a process for forming a concavo-convex pattern in a method for producing a light-emitting element according to an embodiment of the present invention.

Figs. 6(6a) to (6d) are schematic views illustrating the states of the light emission from the light-emitting part of the light-emitting elements produced in Examples 1 and 2 and Comparative Examples 3 and 4, respectively in this order, as observed from the semispherical lens side.

Preferred embodiments of the light-emitting element and the method for producing the same according to the present invention will now be explained with reference to the attached drawings, but the present invention is not limited thereto. In the drawings, the same members are referred to by the same numbers, and description of a member once discussed may later be omitted.

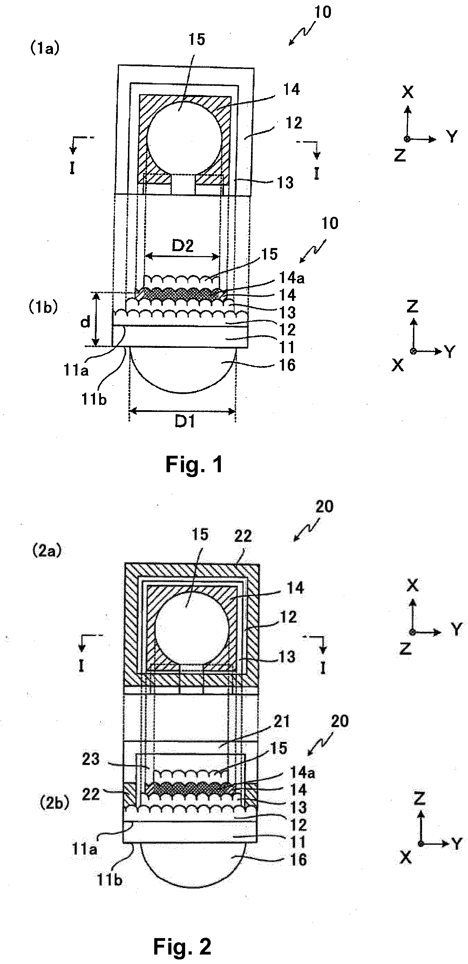

Referring to Figs. 1 (1a) and (1b), a light-emitting element according to an embodiment of the present invention is referred to by 10, and Fig. (1a) is a schematic plan view of the light-emitting element 10, and Fig. (1b) is a schematic sectional view of the element 10 taken along lines I-I in Fig. (1a).

The light-emitting element 10 includes a translucent substrate 11 having a first surface 11a and a second surface 11b opposite from each other, a concavo-convex layer 12, a first electrode layer 13, an organic luminescent layer 14, a second electrode layer 15, and a lens member 16. The concavo-convex layer 12 has a concavo-convex pattern on one of its surfaces, as shown in the figure. The organic luminescent layer 14 has a light-emitting part 14a.

The concavo-convex layer 12, the first electrode layer 13, the organic luminescent layer 14, and the second electrode layer 15 form a laminate in this order from the first surface 11a of the substrate 11, with the concavo-convex pattern of the concavo-convex layer 12 being formed on the side of the first electrode layer 13. The lens member 16 is formed on the second surface 11b of the substrate 11.

Assuming that the plane of each of the opposing first and second surfaces of the substrate 11 defines directions X and Y and the direction perpendicular to this plane is Z, the organic luminescent layer 14 is held in the direction Z by the first electrode layer 13 and the second electrode layer 14 as shown in Fig. (1b), wherein the hatched region is the light-emitting part 14a, which emits light when the light-emitting element 10 is energized.

As shown in Fig. (1a), the second electrode layer 15 has a key-hole shape having a circle and a rectangular terminal connected thereto. In general, a light-emitting part of an organic luminescent layer is a current-carrying region held between the first and second electrodes, but as used herein, the circular region exclusive of the rectangular terminal is defined as a light-emitting part.

The shape of the light-emitting part 14a is not limited to a circle as illustrated, but may be an ellipse or other shape. In this regard, the diameter D2 of the light-emitting part 14a means the diameter or a longer diameter.

The diameter D2 is usually 0.5 to 100 mm, preferably 0.5 to 70 mm, more preferably 0.7 to 70 mm. At less than 0.5 mm, advanced patterning technique is required for the formation of the light-emitting part 14a, whereas at over 100 mm, uniform layering of the laminate may be difficult.

The second electrode layer 15 is usually formed on the organic luminescent layer 14 but, as shown in Fig. (a1), may partly be formed on the concavo-convex layer 12 where the organic luminescent layer 14 is not formed. Here, the second electrode 15 maybe layered so that the concavo-convex pattern formed on the surface of the concavo-convex layer 12 is maintained.

The lens member 16 functions to efficiently extract to outside the light that repeats reflection within the translucent substrate 11. The lens member 16 may usually be those usable for extracting light from an organic EL element, and conventional optical members may suitably be used having a structure that allows extraction of light to the outside of the element. The lens member 16 is a semispherical lens, and may also be a concave lens, a Fresnel lens, or the like.

Diameter D1 of the lens member 16 is preferably 1 to 10 mm in view of ready handling and mechanical strength. With less than 1 mm of D1, it may be difficult to concentrically align the center of the lens member with the center of the light-emitting part 14a, whereas with over 100 mm of D1, the resulting light emitting element will be thick, which may deteriorate the design of various devices in which the element is used.

The center of the light-emitting part 14a is aligned concentrically with the center of the lens member 16. Assuming that the diameter of the lens member 16 is D1 and the diameter of the light-emitting part 14a is D2, the ratio D2/D1 (= r1) is $0.7 < r1 \leq 1.0$. With r1 of not higher than 0.7, when the light emitted from the light-emitting part 14a exits the lens member 16, the area of the light is smaller than that of the lens member 16, which makes it difficult to secure a large light-emitting area.

The sign d in Fig. (1b) indicates the distance from the center of the light-emitting part 14a to the second surface 11b of the substrate 11, and is preferably 0.04 to 5 mm, while the thickness of the substrate 11 is preferably 40 to 3000 $\mu$m.

Referring to Figs. 2 (2a) and (2b), 20 refers to a light emitting element according to another embodiment of the present invention, wherein the light emitting element 10 shown in Fig. 1 is further provided with a sealing member. Fig. (2a) is a schematic plan view of the light emitting element, and Fig. (2b) is a schematic sectional view taken along lines I-I in Fig. (2a).

With regard to the light emitting element 20, explanations of the members indicated by the same numerals as in the light emitting element 10 shown in Fig. 1 will be omitted.

Referring to Fig. (2b), 21 refers to a sealing member arranged facing to the translucent substrate 11 for sealing the laminate of the first electrode layer 12, the organic luminescent layer 14 having the light-emitting part 14a, and the second electrode layer 15.

The sealing member 21 is fixed to the translucent substrate 11 via the concavo-convex layer 12 by means of an adhesive layer 22, as shown in Fig. (2b). The sealing member 21, the adhesive layer 22, the concavo-convex layer 12, and the translucent substrate 11 together form a space 22 that seals the laminate.

The adhesive layer 22 is positioned surrounding the organic luminescent layer 14 in the XY plane as shown in Fig. (2a), and between the concavo-convex layer 12 and the sealing member 21 in the Z direction as shown in Fig. (2b). The adhesive layer 22 is preferably formed apart from the light-emitting part 14a by a certain distance so as not to be in contact with the latter, in order to, for example, efficiently extract the light emitted from the light-emitting part 14a. Preferably, this certain distance is, e.g., not less than 1 $\mu$m.

The space 23 is protected against entry of gaseous matters such as moisture or oxygen. Thus, for example, the organic luminescent layer 14 having the light-emitting part 14a may effectively be inhibited from being deteriorated to improve the service life of the light emitting element 20.

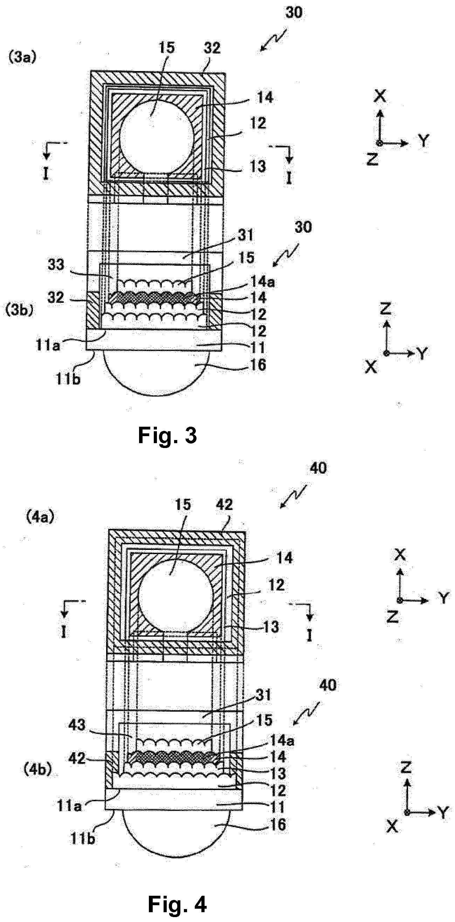

Referring to Figs. 3 (3a) and (3b), 30 refers to a light emitting element according to still another embodiment of the present invention, wherein the position of the adhesive layer in the light emitting element 20 shown in Fig. 2 has been changed. Fig. (3a) is a schematic plan view of the light emitting element 30, and Fig. (3b) is a schematic sectional view taken along lines I-I in Fig. (3a).

With regard to the light emitting element 30, explanations of the members indicated by the same numerals as in the light emitting element 20 shown in Fig. 2 will be omitted.

Referring to Fig. (3b), 31 refers to a sealing member arranged facing to the translucent substrate 11 for sealing the laminate of the concavo-convex layer 12, the first electrode layer 13, the organic luminescent layer 14 having the light-emitting part 14a, and the second electrode layer 15.

The sealing member 31 is fixed to the translucent substrate 11 by means of an adhesive layer 32, as shown in Fig. (3b). The sealing member 31, the adhesive layer 32, and the translucent substrate 11 together form a space 33 that seals the laminate.

The adhesive layer 32 is positioned surrounding the organic luminescent layer 14 in the XY plane as shown in Fig. (3a), and between the translucent substrate 11 and the sealing member 31 in the Z direction, as shown in Fig. (3b). The adhesive layer 32, like the adhesive layer 22 shown in Fig. 2, is preferably formed apart from the light-emitting part 14a by a certain distance so as not to be in contact with the latter.

Since the space 33 completely seals the concavo-convex layer 12, the organic luminescent layer 14 having the light-emitting part 14a may further effectively be inhibited from being deteriorated by the gaseous matters such as moisture or oxygen, which otherwise enterers the space 23 through the concave-convex layer 12 exposed outside in Fig. 2.

Referring to Figs. 4 (4a) and (4b), 40 refers to a light emitting element according to a further embodiment of the present invention, wherein the position of the adhesive layer in the light emitting element 20 shown in Fig. 2 has been changed. Fig. (4a) is a schematic plan view of the light emitting element 40, and Fig. (4b) is a schematic sectional view taken along lines I-I in Fig. (4a).

With regard to the light emitting element 40, explanations of the members indicated by the same numerals as in the light emitting element 20 shown in Fig. 2 will be omitted.

The sealing member 31 is fixed, directly and via part of the concavo-convex layer 12, to the translucent substrate 11 by means of an adhesive layer 42, as shown in Fig. (4b). The sealing member 31, the adhesive layer 42, and the translucent substrate 11 together forma space 43 that seals the laminate.

The adhesive layer 42 is positioned surrounding the organic luminescent layer 14 in the XY plane as shown in Fig. (4a), and between the translucent substrate 11 and the sealing member 31 as well as between the concavo-convex layer 12 and the sealing member 31 in the Z direction as shown in Fig. (4b). The adhesive layer 42 is preferably formed apart from the light-emitting part 14a by a certain distance so as not to be in contact with the latter.

Since the space 43 completely seals the concavo-convex layer 12, the organic luminescent layer 14 having the light-emitting part 14a may further effectively be inhibited from being deteriorated by the gaseous matters such as moisture or oxygen, which otherwise enters the space 23 through the concavo-convex layer 12 exposed outside in Fig. 2. In addition, the adhesive layer 42 provides improved adhesivity, compared to the adhesive layer 32 shown in Fig. 3, due to, e.g., the contact effect of the adhesive layer 42 to the concavo-convex layer 12.

Detailed discussion will be made below on each member of the light emitting element discussed above with reference to Figs. 1 to 4.

Translucent Substrate

As the translucent substrate, conventional transparent substrates may suitably be used that have light-transmitting properties applicable to light-emitting elements. Higher light-transmitting property is preferred. The translucent substrate may be made of, for example, transparent inorganic materials, such as glass; polyesters, such as polyethylene terephthalate, polybutylene terephthalate, polyethylene naphthalate, or polyarylate; acrylic resins, such as polymethylmethacrylate; polycarbonates; polyvinyl chloride; styrene resins, such as ABS resin; cellulose resins, such as triacetyl cellulose; resins of polyimide series, such as polyimide resin or polyimide amide resin; or cycloolefin polymers.

The translucent substrate may be provided with a readily-adhesive layer on its surface for improved adhesion, or with a gas-barrier layer on its surface for preventing infiltration of gaseous matters, such as moisture or oxygen. The translucent substrate may be provided, for example, with a laminated substrate including gas-barrier layers made of an inorganic material, such as SiN, $SiO_2$, SiC, $SiO_xN_y$, $TiO_2$, or $Al_2O_3$, and/or gas-barrier layers made of a resin material; or with a laminated substrate including substrates made of these resins and these gas-barrier layers alternately laminated.

The translucent substrate preferably has heat-resistance and weatherability against UV light or the like, in view of the application to a light emitting element. Such a translucent substrate is more preferably made of an inorganic material, such as glass or quartz. In particular, when the concavo-convex layer is formed of an inorganic material, such as a sol-gel material, a translucent substrate made of an inorganic material may reduce the difference in refraction index between the substrate and the concavo-convex layer, to thereby prevent unintended refraction or reflection in the light-emitting element.

The thickness of the translucent substrate is preferably thin for improved light-extracting efficiency and may be, for example, 40 to 3000 $\mu$m. At less than 40 $\mu$m, handleability and availability may be lowered.

Concavo-convex Layer

The concavo-convex layer is a layer having one of the surfaces formed with fine concavo-convex patterns. The concavo-convex patterns may be of any patterns, such as a micro-lens array structure; a structure having functions, such as optical diffusion or diffraction; a stripe structure composed of dots or lines and spaces; a pillar structure composed of cylinders, circular cones, conical frustums, triangular prisms, triangular pyramids, triangular frustums, square pyramids, square frustums, polygonal prisms, polygonal pyramids, or polygonal frustums; or a hole structure. The concavo-convex patterns may preferably be irregular, for example, lacking even pitches or directivity of concavities and convexities.

The average pitch of the concavities and convexities of the concavo-convex pattern is preferably 100 to 1500 nm, more preferably 200 to 1200 nm, when the concavo-convex layer is to function as a diffraction grating. At less than 100 nm of the average pitch of the concavities and convexities, the pitch is too short relative to the wavelengths of visible light, so that the light tends not to be diffracted at the concavities and convexities, whereas at over 1500 nm, the diffraction angle is small, and the function as a diffraction grating may be lost.

The average pitch of the concavities and convexities means the average of not less than 100 measured distances between the tops of randomly-selected two adjacent convexities or between the bottoms of randomly-selected two adjacent concavities measured in an analysis image of the concavities and convexities taken under a scanning probe microscope. Such an analysis image may be obtained using, for example, E-sweep (trade name) manufactured by HITACHI HIGH-TECHNOLOGIES CORPORATION, under the following conditions:

Measurement mode: cantilever intermittent contact mode Material of cantilever: silicon
Lever width of cantilever: 40 $\mu$m
Diameter of tip of cantilever chip: 10 nm

The average of the depth distribution of the concavities and convexities of the concavo-convex pattern is preferably 20 to 200 nm, more preferably 30 to 150 nm, and the standard deviation of the depth of the concavities and convexities is preferably 10 to 100 nm, more preferably 15 to 75 nm.

With the average of less than 20 nm or the standard deviation of less than 10 nm, the depth of the concavities and convexities is too small relative to the wavelengths of visible light, so that the required diffraction may not be liable to occur. With the average of over 200 nm or the standard deviation of over 100 nm, the diffracted light intensity may not be uniform, which results in, for example, uneven electric field distribution within the organic luminescent layer and localization of electric field, leading to ready leakage, and the service life of the light-emitting element is prone to be short.

The average of the depth distribution and the standard deviation of the depth of the concavities and convexities may be obtained using a scanning probe microscope under the conditions similar to those for the average pitch of the concavities and convexities discussed above, and first by obtaining an analysis image of any 3 $\mu$m or 10 $\mu$m square measurement region of the concavo-convex pattern. In the measurement region, the height data from the bottom of the concavo-convex layer, i.e., the surface of the translucent substrate, to the top of a concavity is obtained in nanometer scale at not less than 16384 measurement points, i.e., 128 points along the length by 128 points along the width of the measurement region. The number of the measurement points may vary depending on the conditions, such as the kind or setting of the measuring apparatus. For example, when the measuring apparatus is the above-mentioned E-sweep (trade name) manufactured by HITACHI HIGH-TECHNOLOGIES CORPORATION, the measurement may be made in a 10 $\mu$m square measurement region at a resolution of 256 by 256 pixels, i.e., 256 points along the length by 256 points along the width, in total of 65536 points.

Next, among the measured height data, measurement point P, which is the highest from the translucent substrate surface among all of the measured points, is determined. Supposing that a plane containing this measurement point P and in parallel to the substrate surface is a reference plane, the difference determined by subtracting the height of the reference plane from each measurement point, from the height of the measurement point P from the substrate surface, is taken as the depth data of the concavities and convexities. The depth data of the concavities and convexities may be determined by automatic calculation by, for example, a software of E-sweep (trade name) manufactured by HITACHI HIGH-TECHNOLOGIES CORPORATION. The arithmetic average and the standard deviation determined from the depth data of the concavities and convexities at each measurement point thus obtained are taken as the average of the depth distribution of the concavities and convexities and the standard deviation of the depth of the concavities and convexities, respectively.

With an irregular concavo-convex pattern, the measurements may be made by processing, by means of a two-dimensional fast Fourier transform, an analysis image of the concavo-convex pattern which is measured using a scanning probe microscope in the same way as above, and determining those having a Fourier-transformed image of a circular or annular pattern. A member having such a pattern has no particular directivity of the concavo-convex pattern, but as long as a quasi-period pattern having a pitch distribution of a concavo-convex pattern is included, and visible light is diffracted, the pattern may suitably be applied to a member used in a light-emitting element, such as organic EL, LED, LEC, or ECL, or a member used in the production of these.

The above-mentioned circular pattern represents that a pattern observed due to gathering of the bright points in the Fourier transformed image is observed generally as a circle, and includes those having partial concavities or convexities in the contour. The above-mentioned annular pattern represents that a pattern formed by gathering of the bright points is observed generally as an annular form, and includes those having partial concavities or convexities in the inner or outer contour.

When a concavity-convexity analysis image obtained by analysis using an atomic force microscope is processed by the two-dimensional fast Fourier transform to obtain a Fourier transformed image, this Fourier transformed image represents a circular pattern approximately around the origin at which the absolute value of the wavenumber is 0 $\mu$m$^{-1}$, and the circular or an annular pattern is present in the region wherein the absolute value of the wavenumber is preferably not more than 10 $\mu$m$^{-1}$, more preferably 0.667 to 10 $\mu$m$^{-1}$, most preferably 0.833 to 5 $\mu$m$^{-1}$. As used herein, "a circular or annular pattern is present in the region wherein the absolute value of the wavenumber is not more than 10 $\mu$m$^{-1}$" means that usually not less than 30%, preferably not less than 50%, still more preferably not less than 80%, most preferably not less than 90%, of the bright points constituting the Fourier transformed image are present in the above-mentioned region wherein the absolute value of the wavenumber is not more than 10 $\mu$m$^{-1}$.

Incidentally, with regard to the relation between a concavo-convex structure and a Fourier transformed image, it is known that when a concavo-convex structure has no pitch distribution or directivity, the Fourier transformed image is also random without any pattern, whereas when a concavo-convex structure is generally isotropic in the XY direction but has a pitch distribution, a circular or annular Fourier transformed image is obtained; and further that when a concavo-convex pattern has a single pitch, the circular ring appearing in a Fourier transformed image tends to be sharp.

As a material of the concavo-convex layer, an inorganic material or a cured product of a resin composition may be used.

The thickness of the concavo-convex layer is preferably 100 nm to 10 $\mu$m. At less than 100 nm, transfer of the concavo-convex shape in the imprinting to be discussed later may be difficult, whereas at over 10 $\mu$m, structural deficiency, such as cracking of the concavo-convex layer, may be liable to occur. As used herein, the thickness of the concavo-convex layer means the average of the distances between the bottom surface of the concavo-convex layer and the surface in which the concavo-convex pattern is formed.

The concavo-convex layer may be provided with an adhesive layer, such as of a silane coupling agent, between the translucent substrate and the concavo-convex layer for improved adhesivity to the substrate. The silane coupling agent may be those having a acryl or methacryl group, for example, commercial products, such as KBM-5103 or KBM-503 (both trade names) manufactured by Shin-Etsu Chemical Co., Ltd.

First Electrode

The first electrode layer may be a generally used transparent electrode layer having translucency, for passing the light from the overlying organic luminescent layer to the translucent substrate side. The first electrode layer may be made of, for example, indium oxide, zinc oxide, tin oxide, or a complex thereof, such as ITO, or gold, platinum, silver, or copper. Among these, ITO is preferred for its transparency and electrical conductivity.

Usually, the thickness of the first electrode layer is preferably 20 to 500 nm. The first electrode layer is not particularly limited regarding its arrangement in the XY direction and its shape, and preferably laminated on the concavo-convex layer so as to keep the concavo-convex pattern formed in the surface of the concavo-convex layer.

Organic Luminescent Layer

The organic luminescent layer is formed on the first electrode layer, but may be formed on the concavo-convex layer where the first electrode layer is not formed. The surface of the organic luminescent layer may be formed so as to keep the concavo-convex pattern of the concavo-convex layer or may be formed flat without keeping the pattern.

The organic luminescent layer is not particularly limited and may be conventional, as long as it may be used generally as an organic layer of an organic EL element. The organic luminescent layer employed in the light-emitting element of the present invention may be, for example, those having a laminate structure composed of a hole transport layer, a luminescent layer, and an electron transport layer. The luminescent layer recombines the holes injected from the first electrode layer and the electrons injected from the second electrode layer for luminescence.

When the organic luminescent layer has the laminate structure composed of a hole transport layer, a luminescent layer, and an electron transport layer, the thicknesses of the hole transport layer, the luminescent layer, and the electron transport layer are preferably 1 to 200 nm, 5 to 100 nm, and 5 to 200 nm, respectively.

The hole transport layer may be made of, for example, phthalocyanine derivatives, naphthalocyanine derivatives, porphyrin derivatives, aromatic diamine compounds, such as N,N'-bis(3-methylphenyl)-(1,1'-biphenyl)-4,4'-diamine or 4,4'-bis(N-(naphthyl)-N-phenylamino)biphenyl, oxazole, oxaziazole, triazole, imidazole, imidazolone, stilbene derivatives, pyrazoline derivatives, tetrahydroimmidazole, polyarylalkane, butadiene, 4,4',4"-tris(N-(3-methylphenyl)-N-phenylamino) triphenylamine, or 4,4',4"-tris(9-carbazole) triphenylamine.

The luminescent layer may be made of a luminescent material, for example, anthracene, naphthalene, pyrene, tetracene, coronene, perylene, phthaloperylene, naphthaloperylene, diphenylbutadiene, tetraphenylbutadiene, coumalin, oxadiazole, bisbenzoxazoline, bisstyryl, cyclopentadiene, organic metal complexes, such as aluminum quinolinol complex, tri(p-terphenyl-4-yl)amine, 1-aryl-2,5-di(2-thienyl)pyrrole derivatives, pyrane, quinacridone, rubrene, distyrylbenzene derivatives, distyrylarylene derivatives, distyrylamine derivatives, or various fluorochromes, and these may suitably be mixed for use. Further, a material system with luminescence from a spin multiplet, such as phosphorescent materials producing phosphorescence, or compounds having in its molecule a part constituted thereof, may also be used suitably. The phosphorescent materials may preferably contain a heavy metal, such as iridium.

The luminescent layer may be a layer wherein a host material having high carrier mobility is doped with the above-mentioned luminescent material as a guest material to generate luminescence by the foerster or dexter mechanism.

The electron transport lay may be made of, for example, nitro-substituted fluorene derivatives, diphenylquinone derivatives, thiopyrandioxide derivatives, heterocyclic tetracarboxylic anhydrides, such as naphthaleneperylene, carbodiimide, fluorenylidenemethane derivatives, anthraquinodimethane and anthrone derivatives, oxadiazole derivatives, or organic metal complexes, such as aluminum quinolinol complex. Further, thiadiazole derivatives wherein the oxygen atom of the oxadiazole ring in the oxadiazole derivatives is substituted with a sulfur atom, or quinoxaline derivatives having a quinoxaline ring known as an electron attractive group, may also be used as an electron transport material. Polymer materials wherein one of these materials is introduced into a polymer chain, or wherein one of these materials is the main chain of the polymer, may also be used.

The hole transport layer or the electron transport layer may also function as a luminescent layer.

Second Electrode Layer

The second electrode layer may suitably be made of a low work-function material, for example, metals, such as aluminum, MgAg, MgIn, or AlLi. The second electrode layer may also be made of a transparent conductive film material, such as ITO, ZnO, or AZO, wherein ZoN is doped with Al, or a thinned low-resistance metal, such as Ag or Au. With such a material, a light-emitting element, such as an organic EL element, which emits light from both the translucent substrate layer side and the second electrode layer side, may be obtained.

The thickness of the second electrode may preferably be 50 to 500 nm.

For facilitating hole injection from the first electrode layer, a hole injection layer may be provided between the organic luminescent layer and the first electrode layer.

The hole injection layer may be made of, for example, triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline copolymers, or oligomers of conductive polymers, such as thiophene oligomers.

For facilitating electron injection from the second electrode layer, an electron injection layer may be provided between the organic luminescent layer and the second electrode layer.

The electron injection layer maybe made of, for example, metal fluorides, such as LiF, metal oxides, such as $Li_2O_3$, highly active alkaline earth metals, such as Ca or Ba, highly active alkaline metals, or organic insulating materials.

Lens Member

The lens member may suitably be any of various members depending on the application, size, or construction of the light-emitting element. For example, for use in an organic EL element of which thickness is not important, a semispherical lens is preferably used, whereas when the thickness is important and a thinner lens preferred, a Fresnel lens is preferably used.

The lens member may be made of a suitable conventional material, for example, transparent inorganic materials, such as glass, or transparent resin materials composed of a transparent polymer, such as polyester resins, e.g., polyethylene terephthalate, cellulose resins, acetate resins, polyether sulfone resins, polycarbonate resins, polyamide resins, polyimide resins, polyolefin resins, or acrylic resins.

The refractive index of the lens member is preferably higher than that of the translucent substrate, and the refractive index at a wavelength of 589 nm is preferably not lower than 1.4, more preferably 1.5 to 2.0.

The lens member is preferably provided with a pressure-sensitive adhesive layer and/or an adhesive layer for avoiding intervention of air between the translucent substrate and the lens member so as to prevent the light reflection therebetween.

The lens member may be provided with a protective layer formed on its surface, such as a transparent film or a transparent inorganic deposited layer, for improving wear resistance or scratch resistance of its surface.

The transparent film may suitably be a conventional transparent film, for example, films of a transparent polymer, such as polyester resins, e.g., polyethylene terephthalate, cellulose resins, acetate resins, polyether sulfone resins, polycarbonate resins, polyamide resins, polyimide resins, polyolefin resins, or acrylic resins. Such a transparent film may be provided with a pressure-sensitive adhesive layer and/or an adhesive layer formed on one of its surfaces, and affixed to the surface of the lens member.

The transparent inorganic deposited layer may be formed with a suitable conventional metal material which may form a transparent inorganic layer by vapor deposition. The metal material may be, for example, oxides, nitrides, or sulfides of a metal, such as Sn, In, Te, Ti, Fe, Co, Zn, Ge, Pb, Cd, Bi, Se, Ga, or Rb. For sufficiently preventing deterioration due to oxidation, $TiO_2$ is preferably used, whereas for achieving a high brightness at a lower cost, ZnS is preferably used. The method for forming the inorganic deposited layer is not particularly limited, and may suitably be performed using a conventional physical vapor deposition apparatus.

Sealing Member

The sealing member may be made of a material having a high gas barrier property. Examples of the material may include conventional gas barrier films used as packaging materials, plastic films on which silicon oxide or aluminum oxide is deposited, laminate films of a ceramic layer and an impact attenuating polymer layer, metal foils laminated with a polymer film, glass or metal sealing can, or engraved glass.

The adhesive layer for fixing the sealing member to the translucent substrate may be made of any adhesive that is generally used with glass or plastic plates. Examples of the adhesives may include polyvinylacetate adhesives, photo-curable or thermosetting acrylic adhesives having a reactive vinyl group, such as acrylate oligomers or methacrylate oligomers, epoxy resin adhesives, moisture-curing adhesives, such as 2-cyanoacrylate esters, ethylene copolymer adhesives, polyester adhesives, polyimide adhesives, amino resin adhesives made of a urea resin, a melamine resin, or the like, phenolic resin adhesives, polyurethane adhesives, reactive (meth)acrylic adhesives, or rubber adhesives, among which acrylic adhesives and epoxy adhesives are preferred, and epoxy adhesives having a low shrinkage upon curing are particularly preferred.

Examples of the epoxy adhesives may include epoxy resin composition composed of an epoxy resin and a curing agent, in which a compound having an epoxy group and a curing agent containing amines or acid anhydride are mixed to cause curing reaction to adhere.

The epoxy adhesives may be commercial products, such as CEMEDINE EP-001 (trade name) manufactured by CEMEDINE CO., LTD.; 3950 series, such as 3950, 3951, or 3952, 2080 series, such as 2083, 2086, or 2087, 2230 series, such as 2230 or 2230B, or 3124C (all trade names) manufactured by THREEBOND; bond MOS series, such as MOS07 or MOS10 (trade names) manufactured by KONISHI CO., LTD.; ULTITE 1500 series, such as ULTITE 1540 (trade name) manufactured by TOHO KASEI KOGYO CO., LTD.; or XNR5576/5576LV, XNR5516/5516HV/5516Z, XNR5570, T470/UR7116, T470/UR7134, T470/UR7132, T470/UR7124E-LV (all trade names) manufactured by NAGASE CHEMTEX CORPORATION.

The acrylic adhesives may be, for example, an adhesive composed of an acrylic pressure-sensitive adhesive component, an energy-ray-curing component, and a thermosetting adhesive component. Such an acrylic adhesive may be a commercial product, such as 3003, 3027B, 3033B, 3042B (all trade names) manufactured by THREEBOND, or CEMEDINE Y600, Y600H (trade names) manufactured by CEMEDINE CO., LTD.

The rubber adhesives may be, for example, adhesives in which an amorphous oligomer, which is a dimer or higher, middle molecular weight polymer with a molecular weight of some hundreds to about ten thousands being in liquid or solid form at ordinary temperature; a thermoplastic resin, such as rosin resins, terpene resins, or petroleum resin; a adhesion promotor, such as chromane-indene resin; and a softener, such as mineral oils, liquid polybutene, liquid polyisobutylene, or liquid polyacrylates, are admixed in at least one adhesive elastomer selected from the group consisting of natural rubbers composed mainly of cis-1,4-polyisoprene, synthetic rubbers mainly composed of styrene-butadiene rubber, polyisobutylene, butyl rubber, or the like, or block rubbers mainly composed of styrene-butadiene-styrene copolymer rubber, styrene-isoprene-styrene copolymer rubber, or the like.

The vinyl ether adhesives may be, for example, adhesive elastomers, such as homopolymers of vinyl methyl ether, vinyl ethyl ether, or vinyl isobutyl ether; or copolymers of these with acrylates; or adhesives wherein the above-mentioned adhesion promotor or softener is admixed therein.

The silicon adhesives may be, for example, adhesives in which the above-mentioned adhesion promotor or softener is admixed with an adhesive elastomer or a polymer having a residual silanol group (SiOH) at an end of a polymer chain, such as high-molecular-weight polydimethylsiloxane or polydimethyl diphenylsiloxane.

Space to be Sealed

The space (23, 33, 44) shown in Figs. 2 to 4 may be filled with a gas containing an inert gas, or the like. The inert gas may preferably be $N_2$, or a noble gas, such as He or Ar, and a noble gas of a mixture of He and Ar may also be preferred. The ratio of the inert gas in the gas that fills the space is preferably 90 to 100 % by volume.

The space may also be filled with a filler composed of a solid or liquid resin, glass, an inactive oil, such as of fluorine based, or a gel material. This filler is preferably transparent or white turbid.

The space maybe provided therein with a water-absorbing material. Such a water-absorbing material may be, for example, barium oxide. The water-absorbing material may be disposed in the space by, for example, affixing high-purity barium oxide powder (ALDRICH CORPORATION) to the sealing member by means of a fluororesin-based semi-ipermeable membrane, MICROTEX S-NTF8031Q (trade name) manufactured by NITTO DENKO CORPORATION, or the like. The water-absorbing material may also preferably be those commercially available from JAPAN CORE TEX or FUTABA CORPORATION.

Next, a method for producing the light-emitting element according to an embodiment of the present invention will be discussed, but a method for producing the light-emitting element of the present invention is not limited thereto.

Referring to Figs. 1 to 4, for forming the concavo-convex layer having the concavo-convex pattern on the first surface of the translucent substrate, first a solution of a sol-gel material is prepared, and applied to the translucent substrate.

The application may be carried out by any method, such as bar coating, spin coating, spray coating, dip coating, die coating, or ink jetting. For the substrate 11 of a relatively large area, bar coating, die coating, or spin coating are preferred since uniform and quick application is possible.

The sol-gel material may preferably be an inorganic material having excellent heat resistance. Examples of such an inorganic material may include sol-gel materials, e.g., metal oxides, such as silica, Ti-based materials, indium-tin-oxide (ITO) materials, ZnO, $ZrO_2$, or $Al_2O_3$, or precursors thereof, such as metal alkoxides, metal acetyl acetonates, metal carboxylates, oxychlorides, chlorides, or mixtures thereof. The metal species of the precursors, other than Si, may be Ti, Sn, Al, Zn, Zr, In, or mixtures thereof. Thesol-gelmaterialmay particularly preferably silica, and silica precursor of a metal alkoxide or the like may also be preferred.

Examples of the silica precursors may include tetraalkoxide monomers represented by tetraalkoxysilanes, such as tetramethoxysilane, tetraethoxysilane (TEOS), tetra-i-propoxysilane, tetra-n-propoxysilane, tetra-i-butoxysilane, tetra-n-butoxysilane, tetra-sec-butoxysilane, or tetra-t-butoxysilane; trialkoxide monomers represented by trialkoxysilanes, such as methyltrimethoxysilane, ethyltrimethoxysilane, propyltrimethoxysilane, isopropyltrimethoxysilane, phenyltrimethoxysilane, methyltriethoxysilane (MTES), ethyltriethoxysilane, propyltriethoxysilane, isopropyltriethoxysilane, phenyltriethoxysilane, methyltripropoxysilane, ethyltripropoxysilane, propyltripropoxysilane, isopropyltripropoxysilane, phenyltripropoxysilane, methyltriisopropoxysilane, ethyltriisopropoxysilane, propyltriisopropoxysilane, isopropyltriisopropoxysilane, phenyltriisopropoxysilane, or tolyltriethoxysilane; and dialkoxide monomers represented by dialkoxysilanes, such as dimethyldimethoxysilane, dimethyldiethoxysilane, dimethyldipropoxysilane, dimethyldiisopropoxysilane, dimethyldi-n-butoxysilane, dimethyldi-i-butoxysilane, dimethyldi-sec-butoxysilane, dimethyldi-t-butoxysilane, diethyldimethoxysilane, diethyldiethoxysilane, diethyldipropoxysilane, diethyldiisopropoxysilane, diethyldi-n-butoxysilane, diethyldi-t-butoxysilane, diethyldi-sec-butoxysilane, diethyldi-t-butoxysilane, dipropyldimethoxysilane, dipropyldiethoxysilane, dipropyldipropoxysilane, dipropyldiisopropoxysilane, dipropyldi-n-butoxysilane, dipropyldi-i-butoxysilane, dipropyldi-sec-butoxysilane, dipropyldi-t-butoxysilane, diisopropyldimethoxysilane, diisopropyldiethoxysilane, diisopropyldipropoxysilane, diisopropyldiisopropoxysilane, diisopropyldi-n-butoxysilane,
diisopropyldi-i-butoxysilane, diisopropyldi-sec-butoxysilane, diisopropyldi-t-butoxysilane, diphenyldimethoxysilane, diphenyldiethoxysilane, diphenyldipropoxysilane, diphenyldiisopropoxysilane, diphenyldiisopropoxysilane, diphenyldi-n-butoxysilane, diphenyldi-i-butoxysilane, diphenyldi-sec-butoxysilane, or
diphenyldi-t-butoxysilane.

The silica precursors may also be alkyl trialkoxysilane or dialkyl dialkoxysilane of which alkyl group has 4 to 18 carbon atoms. Further examples may include monomers having a vinyl group, such as vinyltrimethoxysilane or vinyltriethoxysilane; monomers having an epoxy group, such as 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, or 3-glycidoxypropyltriethoxysilane; monomers having a styryl group, such as p-styryltrimethoxysilane; monomers having a methacrylic group, such as 3-methacryloxypropylmethyldimethoxysilane, 3-methacryloxypropyltrimethoxysilane, 3-methacryloxypropylmethyldiethoxysilane, or 3-methacryloxypropyltriethoxysilane; monomers having an acryl group, such as 3-acryloxypropyltrimethoxysilane; monomers having an amino group, such as N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethylbutylidene)propylamine, or N-phenyl-3-aminopropyltrimethoxysilane; monomers having an ureide group, such as 3-ureidepropyltrimethoxysilane; monomers having a mercapto group, such as 3-mercaptopropylmethyldimethoxysilane or 3-mercaptopropyltrimethoxysilane; monomers having a sulfide group, such as bis(triethoxysilylpropyl)tetrasulfide; monomers having an isocyanate group, such as 3-isocyanatepropyltriethoxysilane; polymers obtained by polymerization of a small amount of these monomers; or metal alkoxides, such as composite materials wherein a functional group or a polymer is introduced in these compounds. Further, compounds wherein all or part of the alkyl or phenyl groups of these monomers or polymers are substituted with fluorine atoms, may also be used.

In addition, mesoporous compound that wherein a surfactant is added to these compounds, may also be used.

The silica precursors may also be a silane coupling agent having in its molecule a hydrolyzable group having affinity or reactivity with silica and an organic functional group having water repellency.

Examples of the silane coupling agent may include silane monomers, such as n-octyltriethoxysilane, methyltriethoxysilane, or methyltrimethoxysilane; vinylsilane, such as vinyltriethoxysilane, vinyltrimethoxysilane, vinyltris(2-methoxyethoxy)silane, or vinylmethyldimethoxysilane; methacrylsilane, such as 3-methacryloxypropyltriethoxysilane or 3-methacryloxypropyltrimethoxysilane; epoxysilane, such as 2-(3,4-epoxycyclohexyl)ethyltrimethoxysilane, 3-glycidoxypropyltrimethoxysilane, or 3-glycidoxypropyltriethoxysilane; mercaptosilane, such as 3-mercaptopropyltrimethoxysilane or 3-mercaptopropyltriethoxysilane; sulfur silane, such as 3-octanoylthio-1-propyltriethoxysilane; or aminosilane, such as 3-aminopropyltriethoxysilane, 3-aminopropyltrimethoxysilane, N-(2-aminoethyl)-3-aminopropyltrimethoxysilane, N-(2-aminoethyl)-3-aminopropylmethyldimethoxysilane, or 3-(N-phenyl)aminopropyltrimethoxysilane; or polymers obtained by polymerizing these monomers.

As the sol-gel material, when, for example, a mixture of TEOS and MTES is used, the mixing ratio may be 1 : 1 by mole. This sol-gel material produces amorphous silica by hydrolysis and polycondensation. In preparing a solution of the sol-gel material, the pH of the solution may be adjusted with acid, such as hydrochloric acid, or alkali, such as ammonia. The pH is preferably not higher than 4 or not lower than 10. Water may be added for hydrolysis. The amount of water to be added may be more than 1.5 folds of the amount of the metal alkoxide species by mole.

The solution of the sol-gel material may be prepared using a solvent, for example, alcohols, such as methanol, ethanol, isopropyl alcohol, or butanol; aliphatic hydrocarbons, such as hexane, heptane, octane, decane, or cyclohexane; aromatic hydrocarbons, such as benzene, toluene, xylene, or mesitylene; ethers, such as diethyl ether, tetrahydrofuran, dioxane; ketones, such as acetone, methyl ethyl ketone, isophorone, or cyclohexanone; ether alcohols, such as butoxyethyl ether, hexyloxyethyl alcohol, methoxy-2-propanol, or benzyloxy ethanol; glycols, such as ethylene glycol or propylene glycol; glycol ethers, such as ethylene glycol dimethyl ether, diethylene glycol dimethyl ether, or propylene glycol monomethyl ether acetate; esters, such as ethyl acetate, ethyl lactate, or $\gamma$-butyrolactone; phenols, such as phenol or chlorophenol; amides, such as N,N-dimethylformamide, N,N-dimethylacetoamide, or N-methylpyrrolidone; halogen solvents, such as chloroform, methylene chloride, tetrachloroethane, monochlorobenzene, or dichlorobenzene; hetero-element-containing compounds, such as carbon disulfide; water; or mixed solvents thereof. Among these, ethanol or isopropyl alcohol is particularly preferred, and a mixture of these with water may also be preferred.

Various additives may be added to the solution of the sol-gel material. Examples of the additives may include viscosity modifiers, such as polyethylene glycol, polyethyleneoxide, hydroxypropyl cellulose, or polyvinyl alcohol; alkanolamines, such as triethanolamine; β-diketone, such as acetylacetone; or solution stabilizers, such as β-ketoesters, formamide, dimethylformamide, or dioxane. Further, materials may also be used that generate acid or alkali when irradiated with light, such as energy rays represented by ultraviolet rays, e. g. , excimer UV light. With the addition of such a material, the solution of the sol-gel material may be cured by light irradiation.

For improved adhesion, in applying the solution of the sol-gel material on the translucent substrate, the translucent substrate may be surface-treated or provided with a readily-adhesive layer, or for the purpose of preventing infiltration of gaseous matters, such as moisture or oxygen, the translucent substrate maybe provide thereon a gas barrier layer.

After the application of the solution of the sol-gel material, the translucent substrate may preferably be held in the atmosphere or under reduced pressure for evaporation of the solvent in the coating film. When this retention time is too short, the viscosity of the coating film is too low and the concavo-convex pattern may not be transferred to the coating film, whereas when the retention time is too long, the polymerization of the precursor of the sol-gel material may proceed to cause increase in the viscosity of the coating film, and the concavo-convex pattern may not be transferred to the coating film.

After the application of the solution of the sol-gel material, the polymerization of the precursor of the sol-gel material proceeds as the evaporation of the solvent proceeds, so that the properties of the sol-gel material, such as viscosity, change in a short time. In view of the stability of the concavo-convex pattern formation, it is preferred that the drying time range in which good pattern transfer is achieved, is sufficiently wide. The drying time may be controlled by means of, e.g., the drying temperature, dryingpressure, kinds of the sol-gel material, mixing ratio of the sol-gel material species, or amount of the solvent used in the preparation of the sol-gel material.

Next, the concavo-convex pattern is transferred, using a mold for concavo-convex pattern transfer, to the coating film of the sol-gel material formed on the translucent substrate as discussed above, to thereby form the concavo-convex layer.

The mold for the concavo-convex pattern transfer may be a film mold or a metal mold, and the former is preferred for its flexibility and plasticity. The mold may be pressed onto the coating film of the sol-gel material by means of a pressure roll. The roll method with a pressure roll, compared to the press method, is advantageous in that: pattern collapse due to the difference in coefficient of thermal expansion between the mold, the substrate, and the stage on which the substrate is mounted, may be prevented since the contact time between the mold and the coating film is short; generation of bubbles of gas or traces thereof in the pattern due to bumping of the solvent in the solution of the sol-gel material, may be prevented; the transfer pressure and the peel force may be made low since the mold is line-contacted with the coating film on the substrate, which provides compatibility to larger areas; and bubbles are not entangled during pressing.

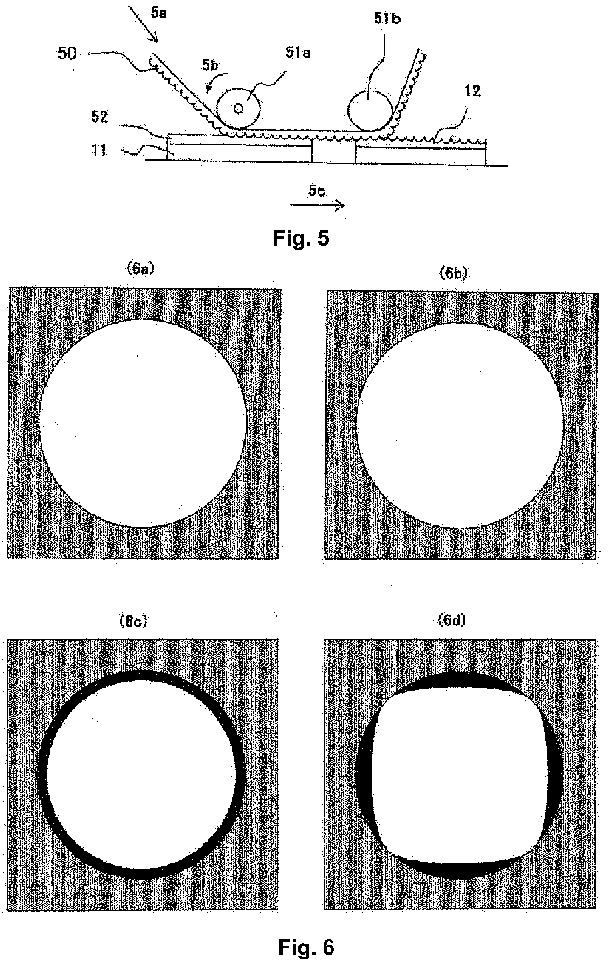

In the roll method, the substrate may be heated while the mold is pressed thereto. ReferringtoFig. 5, anexample will be discussed, wherein the concavo-convex layer is formed by pressing the film mold onto the coating film of the sol-gel material by means of a pressure mold. In Fig. 5, the members that are the same as those in Figs. 1 to 4 are referred to by the same numbers.

In Fig. 5, the film mold, referred to by 50, is sequentially fed to press, by means of a pressure roll 51a, the coating film 52 of the sol-gel material on the translucent substrate 11 transferred into immediately below the roll, so that the concavo-convex pattern of the film mold 50 is transferred onto the coating film 52 to form a concavo-convex layer 12. In Fig. 5, arrow a indicates the travelling direction of the film mold 50, arrow b the direction of rotation of the pressure roll 51, and arrow c the direction of transfer of the translucent substrate 11. Incidentally, in Fig. 5, 51b refers to a peeling roll, which will be discussed later.

For pressing the film mold 50 onto the coating film 52 by means of the pressure roll 51a, while the film mold 50 and the translucent substrate 11 are transferred synchronously, the surface of the coating film 52 on the translucent substrate 11 is covered with the film mold 50. Here, by rotating the pressure roll 51a while pressing onto the surface of the film mold 50 opposite to the surface having the concavo-convex pattern, the film mold 50 and the translucent substrate 11 are contacted tightly while advancing.

When the film mold 50 is long, it is convenient to use a film roll on to which the long film mold is wound, and feed the long filmmold from the film roll toward the pressure roll.

The film mold used in this embodiment is a mold having on one of the two surfaces of the film a concavo-convex pattern to be transferred. The concavo-convex pattern may be formed directly in the film, or a material having the concavo-convex pattern may be formed on the film. The material having the concavo-convex pattern may be, for example, a photosetting resin, a thermosetting resin, or a thermoplastic resin.

The size of the film mold, in particular the length, may suitably be decided depending on the size of the mass-produced translucent substrates, or the number of the lots of the translucent substrate to be continuously used in a single manufacturing process. For example, when a film mold of as long as 10 m or more is to be used, the film mold is wound up on a roll in advance, and the film mold, while continuously fed from the roll, may continuously transfer the concavo-convex pattern to a plurality of translucent substrates.

The width of the film mold may usually be 50 to 3000 mm, and the thickness of the film mold may usually be 1 to 500 $\mu$m.

When the film mold prepared by forming on the film a material having a concavo-convex pattern is to be used, the film may be subjected to surface treatment or easy-adhesion treatment for improved adhesion between the film and the material having a concavo-convex pattern. The concavo-convex pattern may be subjected to releasing treatment on the surface.

The concavo-convex pattern formed in the film mold may be similar to the concavo-convex pattern of the concavo-convex layer discussed above.

An example of a method for producing the film mold will be discussed below, but the method is not limited thereto.

First, a matrix having a concavo-convex pattern for forming the concavo-convex pattern of the film mold is produced. The concavo-convex pattern of the matrix may preferably be formed, for example, by a method utilizing micro phase separation, which is self-organization of a block copolymer by heating (referred to as Block Copolymer (BCP) heat annealing hereinbelow) disclosed in WO 2012/096368, a method utilizing self-organization of BCP in a solvent atmosphere (referred to as BCP solvent annealing hereinbelow) disclosed in WO 2013/161454, or a method for forming concavities and convexities with wrinkles on polymer surface by heating and cooling a membrane vapor-deposited on a polymer film (referred to as Buckling (BKL) hereinbelow) disclosed in WO 2011/007878 A1. Instead of BCP heat annealing, BKL, or BCP solvent annealing, photolithography may be employed. The concavo-convex pattern of the matrix may otherwise be formed, for example, by microfabrication, such as cutting, electron beam direct drawing, particle beam processing, or scanning probe microscopy, or microfabrication employing self-organization of fine particles. Further, the concavo-convex pattern obtained by BCP solvent annealing may be etched by irradiation with energy rays represented by ultraviolet rays, such as excimer UV light, or dry-etched, such as by reactive ion etching, and the etched concavo-convex pattern may further be heat-treated.

In the formation of the concavo-convex pattern by BCP heat annealing or BCP solvent annealing, the matrix may be made of any material, preferably BCP composed of a combination of two members selected from the group consisting of, for example, styrene polymers, such as PS, polyalkylmethacrylate, such as PMMA, polyethylene oxide, polybutadiene, polyisoprene, polyvinylpyridine, and polylactic acid.

After the matrix having a concavo-convex pattern is prepared, a mold to which the concavo-convex pattern of the matrix is transferred is produced by the following electroforming, or the like method.

First, a seed layer acting as an conductive layer for the electroforming is formed on the matrix having a concavo-convex pattern by nonelectrolytic plating, sputtering, or vapor deposition. The thickness of the seed layer is preferably not less than 10 nm for uniform current density during electroforming, and uniform thickness of the metal layer deposited by electroforming.

The seed layer may be formed by, for example, nickel, coper, gold, silver, platinum, titanium, cobalt, tin, zinc, chromium, a gold-cobalt alloy, a gold-nickel alloy, a boron-nickel alloy, solder, a copper-nickel-chromium alloy, a tin-nickel alloy, a nickel-palladium alloy, a nickel-cobalt, phosphorus alloy, or an alloy of two or more of these.

Next, a metal layer is deposited on the seed layer by electroforming. The thickness of the metal layer, together with that of the seed layer as a whole, may usually be 10 to 3000 $\mu$m. The metal layer to be deposited by electroforming may be made of the metal species listed above for use in the formation of the seed material. The metal layer is preferably regulated to have a hardness and thickness suitable for facilitating the subsequent process for the mold formation, such as pressuring and releasing of a resin layer, or washing.

The metal layer with the seed layer thus obtained is peeled off of the matrix having a concavo-convex pattern to give a metal substrate having the concavo-convex pattern transferred thereon. The peeling may either be physical peeling, or by dissolving with an organic solvent the material having the concavo-convex pattern formed in the matrix. The organic solvent may be, for example, toluene, tetrahydrofuran, or chloroform.

The residual material component from the matrix left on the metal substrate peeled off of the matrix maybe removed by washing. The washing may be wet washing with a surfactant or the like, or dry washing with ultraviolet rays or plasma. The residual material component may also be removed by causing the component to adhere to a pressure-sensitive adhesive or an adhesive. In this way, a metal substrate on which the concavo-convex pattern has been transferred from the matrix is obtained.

The metal substrate thus obtained may be used as it is as a concavo-convex pattern transfer mold for forming a concavo-convex layer, or the film mold discussed above may be produced using this metal substrate.

The film mold may be produced by transferring the concavo-convex pattern of the metal substrate onto a film-shaped supporting substrate. For example, a film mold may be obtained by applying a curing resin to a supporting substrate, curing the curing resin layer while the concavo-convex pattern of the metal substrate is pressed against the curing resin layer, to form a cured resin layer to which the concavo-convex pattern has been transferred, and peeling the metal substrate from the supporting substrate.

The supporting substrate may be, for example, a substrate made of an inorganic material, such as glass, quartz, or silicon, a substrate made of an organic material, such as a silicon resin, polyethyleneterephthalate (PET), polyethyleneterenaphthalate, polycarbonate, cycloolefin polymer, polymethylmethacrylate (PMMA), polystyrene (PS), polyimide, or polyarylate, or a substrate made of a metal material, such as nickel, copper, or aluminum. The thickness of the supporting substrate may usually be 1 to 500 μm.

Examples of the curing resin may include various resins, such as epoxy, acryl, methacryl, vinyl ether, oxetane, urethane, melamine, urea, polyester, polyolefin, phenol, cross-linked liquid crystal, fluorine, silicon, or polyamide monomers, oligomers, or polymers. The thickness of the resulting cured resin layer may preferably be 0.5 to 500 μm. At less than 0.5 μm, the height of the concavities and convexities formed in the cured resin layer tends to be insufficient, whereas at over 500 μm, the volume change occurred upon curing has a substantial effect to impede proper formation of the concavo-convex pattern.

The curing resin may be applied to the supporting substrate by various coating method, for example, spin coating, spray coating, dip coating, instillation, gravure printing, screen printing, relief printing, die coating, curtain coating, ink jet, or sputtering.

The conditions for curing the curing resin may vary depending on the kind of the resin. For example, the curing temperature is preferably the room temperature to 250 °C, and the curing time is preferably 0.5 minutes to 3 hours. When the curing resin is cured by irradiation with energy rays, such as ultraviolet rays or electron beams, the irradiance level may preferably be 20 mJ/cm$^2$ to 5 J/cm$^2$.

Next, the metal substrate is peeled off of the supporting substrate having the cured resin layer formed thereon, to give a film mold. The metal substrate may be peeled off by any conventional method, not limited to mechanical peeling.

After a mold, such as the film mold discussed above, is pressed against the coating film of the sol-gel material by the above-mentioned method as illustrated in Fig. 5, the coating film may be pre-baked. By this pre-baking, the gelation of the coating film proceeds, and the concavo-convex pattern is fixed so as not to lose its shape easily during releasing from the pressure roll. The pre-baking, if employed, may preferably be performed by heating at 40 to 150 °C in the atmosphere.

The pre-baking is not essential. When the material that generates acid or alkali when irradiated with light is added to the solution of the sol-gel material, pre-baking of the coating film may be replaced by irradiation with energy rays represented by ultraviolet rays, such as excimer UV light.

Next, the mold is peeled off of the coating film of the sol-gel material. The mold may be peeled off by a conventional method. For example, the mold may be peeled off under heating, which allows the gas generated from the coating film of the sol-gel material to escape and prevents formation of bubbles in the film. When the roll method is employed, compared to the press method, the mold may be peeled off with a smaller force, and the coating film may be inhibited from remaining on the mold and easily peeled off. In particular, by pressing the coating film of the sol-gel material under heating, the reaction easily proceeds, and the mold may easily be peeled off of the coating film of the sol-gel material immediately after pressing.

For improved release of the mold, a release roll may be used. As shown in Fig. 5, a release roll 51b may be positioned downstream of the pressure roll 51a, and by rotationally supporting the film mold 50 urged against the coating film 52 by means of the release roll 51b, the film mold 50 is maintained in attachment to the coating film 52 for a certain period of time over the distance between the pressure roll 51a and the release roll 51b. By turning the film mold 50 upwards at a location downstream of the release roll 51b, the film mold 50 may be peeled off of the concavo-convex layer 12 onto which the concavo-convex pattern has been transferred. As discussed above, the coating film 52 may be pre-baked or heated while the film mold 50 is attached to the coating film 52. When the release roll 51 is used, for example, the film mold 50 may be still more easily peeled off under heating at 40 to 150 °C. In this way, the concavo-convex layer 12 may be formed.

According to this embodiment, sintering may cause elimination of the hydroxyl groups or the like contained in silica, such as amorphous silica, which constitutes the concavo-convex layer of the sol-gel material, to firmly cure the sol-gel material. The sintering may be performed usually at 200 to 1200 °C for about 5 minutes to 6 hours.

When the resulting concavo-convex layer is made of silica, the concavo-convex layer may be amorphous, crystalline, or in a mixed state of amorphous and crystalline, depending on the temperature or time of the sintering. When the solution of the sol-gel material contains the material that generates acid or alkali when irradiated with light, the sintering may be replaced by irradiation with energy rays represented by ultraviolet rays, such as excimer UV light, to cure the coating film.

The obtained concavo-convex layer may be brush-washed for removing foreign matters adhered on its surface, and cleaned with an alkaline detergent in an aqueous solvent or an organic solvent for removing organic substances.

On the surface of the obtained concavo-convex layer, a covering layer covering the concavo-convex pattern may be formed for covering possible foreign matters or defects on the surface, to effectively inhibit leak current of the resulting light-emitting element. The covering layer preferably has a film thickness falling under 25 to 150 % of the standard deviation of the depth of the concavities and convexities of the concavo-convex layer. With the covering layer of such a film thickness, the efficiency of light extraction of the light-emitting element may further be improved.

The covering layer may be made of a material similar to the sol-gel material used for forming the concavo-convex layer, and preferably the same material as used for forming the concavo-convex layer. By forming the concavo-convex layer and the covering layer with the same material, the light reflection at the interface therebetween may be suppressed.

The covering layer maybe formed with the sol-gel material by applying the solution of the sol-gel material to the concavo-convex layer and curing the same. The solvent of the solution of the sol-gel material may be those used in the material for forming the concavo-convex layer. The solution of the sol-gel material may also contain the additives used in the formation of the concavo-convex layer.

The solution of the sol-gel material for forming the covering layer may preferably be a solution diluted further with a solvent from the solution of the sol-gel material used in the formation of the concavo-convex layer, for facilitating formation of the covering layer at a desired, thinner film thickness compared to the concavo-convex layer.

The covering layer may be formed of, for example, an inorganic material, such as $TiO_2$, ZnO, ZnS, ZrO, $BaTiO_3$, $SrTiO_2$, with TiO2 being preferred in view of film-forming properties and refractive index.

The covering layer may also be formed of a curing resin. The curing resin may preferably be a material similar to the material of the curing resin for forming the concavo-convex layer to be discussed later.

As a material for forming the covering layer, a silane coupling agent may be used. In this way, adhesion between the covering layer and the overlying layer, such as an electrode formed thereon, may be improved, or the resistance may be improved in the washing process or the high-temperature processing during the manufacture of the light-emitting element.

The silane coupling agent may be of any kind without limitation, and may be, for example, a compound represented by the formula $RSiX_3$, wherein R is an organic functional group including at least one member selected from the group consisting of vinyl, glycidoxy, acryl, methacryl, amino, and mercapto groups.

The material for forming the covering layer may also contain, for example, a ultraviolet-absorbing material. The ultraviolet-absorbing material absorbs ultraviolet rays to convert the light energy to harmless heat or the like, to thereby suppress deterioration of the covering layer. The ultraviolet absorbing agent may be a conventional agent, such as benzotriazole absorbers, triazine absorbers, salicylic acid derivative absorbers, or benzophenone absorbers.

The covering layer may also be formed of a polysilazane solution. The polysilazane solution, when applied onto the concavo-convex layer, may cause silica modification of the resulting coating film into ceramics to form a covering layer of silica. As used herein, polysilazane is a polymer having a silicon-nitrogen bond, and composed of a ceramic precursor inorganic polymer, such as $SiO_2$, $Si_3N_4$, and an intermediate solid solution of these $SiO_xN_y$, having Si-N, Si-H, N-H, or the like. A compound represented by formula (1) disclosed in JP-H08-112879-A, which is modified into ceramics at a relatively low temperature and into silica, is preferred:

$$-Si(R1)(R2)-N(R3)- \qquad (1)$$

wherein R1, R2, and R3 each independently is a hydrogen atom, or an alkyl, alkenyl, cycloalkyl, aryl, alkylsilyl, alkylamino, or alkoxy group.

The compound represented by the formula (1) may particularly preferably be perhydropolysilazane, wherein all of R1, R2, and R3 are hydrogen atoms, or organopolysilazane, wherein part of hydrogen bound to Si is substituted with an alkyl group or the like.

Other examples of polysilazane that is converted into ceramics at a low temperature may include silicon-alkoxide-added polysilazane obtained by reacting silicon alkoxide with polysilazane, as disclosed in JP-H05-238827-A; glycidol-added polysilazane obtained by reacting glycidol, as disclosed in JP-H06-122852-A; alcohol-added polysilazane obtained by reacting alcohol, as disclosed in JP-H06-240208-A; metal-carboxylate-added polysilazane obtained by reacting metal carboxylate, as disclosed in JP-H06-299118-A; acetylacetonato-complex-added polysilazane obtained by reacting acetylacetonato complex containing metal, as disclosed in JP-H06-306329-A; and metal-fine-particle-added polysilazane obtained by adding metal fine particles, as disclosed in JP-H07-196986-A.

The solvent of the polysilazane solution may be, for example, a hydrocarbon solvent, such as aliphatic hydrocarbon, alicyclic hydrocarbon, or aromatic hydrocarbon; a halogenized hydrocarbon solvent; or ethers, such as aliphatic ethers or alicyclic ethers. Further, for promoting modification into silicon oxide compounds, amine or metal catalyst may be added to the polysilazane solution.

The surface of the concavo-convex layer or the covering layer may be subjected to hydrophobic treatment. The hydrophobic treatment may be carried out by a conventional method. For example, when the surface is made of silica, hydrophobic treatment with dimethyldichlorosilane, trimethylalkoxysilane, or the like; with a trimethylsilylating agent, such as hexamethyldisilazane, and silicon oil; or with metal oxide powders using supercritical carbon dioxide may becarriedout. By making the surface hydrophobic, water removal in the manufacturing process of the light-emitting elements is facilitated, which may prevent generation of defects, such as dark spots, in the resulting light-emitting elements, or deterioration of the device.

Further, the concavo-convex layer may be provided on its surface a gas barrier layer for the purpose of preventing infiltration of gaseous matters, such as moisture or oxygen.

Next, a first electrode layer is formed on the concavo-convex layer or the covering layer so that the concavo-convex pattern of the concavo-convex layer is maintained, to give a first electrode layer having the concavo-convex pattern.

The first electrode layer may be formed, for example, by forming a coating film of the material of the first electrode layer, applying photoresist on the coating film to form a mask pattern of the first electrode, exposing the mask pattern, developing with a developing solution, and etched with an etching solution, to thereby give a first electrode layer of a particular pattern. The coating layer may be formed by a suitably selected conventional method, such as vapor deposition, sputtering, or spin coating. Sputtering is preferred for improved adhesion, though the substrate may be exposed to a temperature as high as 300 °C.

The obtained first electrode layer is preferably brush-washed, and cleaned with an alkaline detergent in an aqueous solvent or an organic solvent for removing organic substances, and then UV ozone treated.

Then, an organic luminescent layer is formed on the first electrode layer. The organic luminescent layer may be formed, for example, by forming an organic layer through a suitably selected conventional method, such as vapor deposition, sputtering, spin coating, or die coating, and then patterning by a conventional patterning process using a mask of a prescribed shape arranged thereon.

Then, a second electrode layer is formed on the organic luminescent layer. The second electrode layer may be formed, for example, by forming a coating film through a conventional method, such as vapor deposition or sputtering, and then patterning by a conventional patterning process using a mask of a prescribed shape arranged thereon.

Through the above-described steps, the translucent substrate may be provided, on its first surface, a laminate of at least the concavo-convex layer, the first electrode layer, the organic luminescent layer, and the second electrode layer, formed in this order.

The lens member may be formed on the second surface of the translucent substrate via a pressure-sensitive adhesive layer and/or an adhesive layer.

The pressure-sensitive adhesive layer or the adhesive layer may be formed of a suitably selected conventional material that is capable of affixing the lens member on the translucent substrate. Examples may include acrylic pressure-sensitive adhesives, ethylene-vinyl-acetate copolymer pressure-sensitive adhesives, natural rubber pressure-sensitive adhesives, or synthetic rubber pressure-sensitive adhesives, such as polyisobutylene, butyl rubber, styrene-butylene-styrene copolymers, styrene-isoprene-styrene block copolymers, polyurethane pressure-sensitive adhesives, and polyester pressure-sensitive adhesives. Commercially available products may be, for example, UV-setting optical adhesives, NOA60, NOA61, NOA71, NOA72, NOA81 (all trade names) manufactured by NORLAND, or UV-3400 (trade name) manufactured by TOAGOSEI CO., LTD.

For the pressure-sensitive adhesive layer and the adhesive layer, it is preferred to use a pressure-sensitive adhesive or an adhesive that has a refractive index equivalent to that of the translucent substrate so as not to affect the light path coming out of the translucent substrate.

The pressure-sensitive adhesive and the adhesive may be applied by any suitably selected conventional method without particular limitation. The pressure-sensitive adhesive and the adhesive may be applied to at least one of the translucent substrate and the lens member.

The order of forming the lens member is not particularly limited and may be formed, for example, before or after the formation of the concavo-convex layer, or even after the sealing step to be discussed later.

In this way, the light-emitting element as shown in Fig. 1 may be produced.

Sealing Step

As shown in Figs. 2 to 4, a sealing member is formed to seal the above-mentioned laminate. Such a sealing member may be formed first by forming an adhesive layer surrounding the organic luminescent layer on the surface of the translucent substrate having the concavo-convex layer. The adhesive layer may be formed at a desired position by applying an adhesive using a scannable dispenser and/or a movable stage, or the like. By controlling the scanning speed or the discharge rate of the dispenser, the adhesive layer may be formed in a desired line width.

Next, the sealing member is arranged facing to the translucent substrate above the concavo-convex layer, the first electrode layer, the organic luminescent layer, and the second electrode layer, as illustrated in Figs. 2 to 4, and adhered to the translucent substrate via the adhesive layer, to seal the space between the translucent substrate and the sealing member.

When the adhesive layer is made of a material which is cured by energy ray irradiation, the adhesive layer, after the sealing, is cured by irradiation of energy rays. For example, in the case of a photosetting adhesive, the adhesive layer may be cured by irradiation with light of the ultraviolet to visible region obtained by a high-pressure mercury vapor lamp or a halogen lamp, from the sealing member side or the translucent substrate side. When the adhesive layer is thermosetting, the adhesive may be cured by heating, e.g., at 50 to 150 °C. In this way, the translucent substrate and the sealing member are integrated, and at least the organic luminescent layer is arranged inside the sealed space.

After the formation of the organic luminescent layer, the sealing is preferably performed, for example, in nitrogen atmosphere inside a glove box substituted with a high purity nitrogen gas of not lower than 99. 999 % purity, without exposing the organic luminescent layer to the atmosphere.

After the sealing member is placed facing to the translucent substrate, the adhesive may be injected into the resulting sealed space to form the adhesive layer. Through the production method discussed above, the light-emitting elements having the sealing member as shown in Figs. 2 to 4 may be produced.

In the embodiment discussed so far, the concavo-convex layer is formed with a sol-gel material, but the sol-gel material of an inorganic material may be replaced with a curing resin. Examples of such a curing resin may include photosetting, thermosetting, moisture-curing, and two-component chemical curing resins. Specifically, various resins may be used, such as epoxy, acryl, methacryl, vinyl ether, oxetane, urethane, melamine, urea, polyester, polyolefin, phenol, cross-linked liquid crystal, fluoride, silicon, or polyamide monomers, oligomers, or polymers.

For forming the concavo-convex layer with a curing resin, for example, the curing resin is applied to the translucent substrate, and then while a mold having a fine concavo-convex pattern is pressed against the applied curing resin layer, the coating film is cured, to thereby transfer the concavo-convex pattern of the mold to the curing resin layer. The curing resin may be diluted with an organic solvent before application. The organic solvent may be selected from the solvents that dissolve the uncured resin. For example, the organic solvent may be selected from the conventional solvents, e.g., alcohol solvents, such as methanol, ethanol, or isopropyl alcohol; or ketone solvents, such as acetone, methyl ethyl ketone, or methyl isobutyl ketone.

The curing resin may be applied by various coating methods, such as spin coating, spray coating, dip coating, instillation, gravure printing, screen printing, relief printing, die coating, curtain coating, ink jet, or sputtering. The mold having a fine concavo-convex pattern may be any desired mold, such as the film mold or the metal mold discussed above.

The conditions for curing the curing resin may vary depending on the kind of the resin and, for example, the curing temperature is preferably within the range of the room temperature to 250 °C, and the curing time is preferably within the range of 0.5 minutes to 3 hours. When the curing resin is cured by irradiation with energy rays, such as ultraviolet rays or electron beams, the irradiance level may preferably be 20 mJ/cm$^2$ to 5 J/cm$^2$.

In the above, the optical substrate having an organic luminescent layer according to the embodiments of the present invention has been discussed for use as a diffraction grating substrate of an organic EL element of a bottom emission type, but the light-emitting element of the present invention is not limited to such application. As the optical substrates according to the embodiments of the present invention, the present invention also encompasses organic EL elements of a top emission or a transmission type.

The present invention will now be explained with reference to Examples and Comparative Example, which are not intended to limit the present invention.

Example 1

To 230 mg of BCP (POLYMER SOURCE INC.) and 57.5 mg of polyethylene glycol 2050 (ALDRICH, number average molecular weight (Mn) is 2050), toluene was added to make the total weight to 15 g and dissolve, and the resulting solution was filtered through a 0.5 μm membrane filter, to obtain a BCP solution.

The BCP used here is now discussed.

The BCP was composed of PS-PMMA segments, wherein the Mn of the PS segment was 680000, the Mn of the PMMA segment was 580000, and the Mn of the BCP was 1260000, the ratio of the PS segment to the PMMA segment was 57 : 43 by volume, the molecular weight distribution (Mw/Mn) was 1.28, the glass transition temperature (Tg) of the PS segment was 107 °C, and the Tg of the PMMA segment was 134 °C.

The volume ratio of the PS and PMMA segments was calculated assuming that the density of PS was 1.05 g/cm$^3$ and the density of PMMA was 1.19 g/cm$^3$. The Mn and Mw were determined by gel permeation chromatography using Model GPC-8020 containing series connected TSK-GEL Super H1000, Super H2000, Super H3000, and Super H4000, manufactured by TOSOH CORPORATION. The Tg was determined using a differential scanning calorimetry (trade name DSC7, PERKIN-ELMER) over the temperature range of 0 to 200 °C at a temperature raising rate of 20 °C per minute. The solubility parameters of PS and PMMA were 9.0 and 9.3, respectively (see KAGAKU BINRAN (Chemical Handbook), Ouyou-Hen, Second Revision).

Next, a mixed solution of 1 g of a silane coupling agent (trade name KMB-5103, SHIN-ETSU SILICONE), 1 g of ion exchanged water, 0.1 mL of acetic acid, and 19 g of isopropyl alcohol was applied to a glass substrate by spin coating, and heated at 130 °C for 15 minutes, to thereby obtain a glass substrate surface-treated with the silane coupling agent. The spin coating was performed first at 500 rpm for 10 seconds and then at 800 rpm for 45 minutes.

Onto the surface-treated glass substrate, the BCP solution prepared above was applied by spin coating in a 140 to 160 nm film thickness, to obtain a glass substrate with a BCP thin film. The spin coating was performed first at 200 rpm for 10 seconds and then at 300 rpm for 30 seconds.

Next, in a 5L desiccator, a screw bottle containing 100 g of chloroform was placed to fill the atmosphere with chloroform at saturated vapor pressure. In this desiccator, the glass substrate with the BCP thin film was placed stationarily at room temperature for 24 hours to undergo phase separation by solvent annealing. A section of the resulting BCP thin film was observed under a transmission electron microscope (TEM) (trade name H-7100FA, HITACH, LTD.) to find that PS having a circular horizontal section was arranged apart from each other in the direction parallel to the glass substrate surface and vertically in two layers. Considering an analysis image of an atomic force microscope, it was determined that the cylindrical PS was horizontally phase-separated from the PMMA segment. In other words, a corrugated pattern of microphase-separated PS and PMMA was observed on the surface of the BCP thin film.

On the surface of the BCP thin film having the corrugated pattern, a 20 nm thick nickel layer was formed as a seed layer by sputtering. Then, the thin film was placed in a nickel sulfamate bath, and subjected to electroforming at 500 °C at the maximum current density of 0.05 A/cm$^2$ to precipitate nickel until the nickel layer grew to 250 $\mu$m, to thereby obtain an electroformed nickel film. The glass substrate having the BCP thin film was mechanically peeled off, and the resulting electroformed nickel film was soaked in tetrahydrofuran for 2 hours. Then, an UV curing acrylic resin was applied to the obtained electroformed nickel film to cure and was peeled off, which was repeated three times, to remove the polymer attached to the surface of the electroformed film. The film was then soaked in an alkaline detergent (trade name CHEMISOL 2303, JAPAN CEE-BEE CHEMICAL CO., LTD.), washed under stirring at 50 °C for 2 hours, and treated with UV/ozone for 10 minutes.

The electroformed nickel film thus obtained was soaked in a fluorine mold release agent (trade name HD-2101TH, DAIKIN INDUSTRIES, LTD.) for about one minute, dried, and left to stand still overnight. On the following day, the electroformed nickel film was soaked in HDTH (DAIKIN INDUSTRIES, LTD.) for about one minute for ultrasonic cleaning, to thereby obtain a nickel film mold.

Next, an UV curing fluorine resin was applied to a PET film (trade name COSMOSHINE A-4100, TOYOBO CO., LTD.), and irradiated with ultraviolet rays at 600 mJ/cm$^2$ to cure the resin, while the nickel film mold was pressed against the film. Then the nickel film mold was peeled off to obtain a film mold. The film mold thus obtained had the surface profile of the nickel film mold transferred thereto.

To a mixed solution of 22 moles of ethanol, 5 moles of water, 0.004 moles of concentrated hydrochloric acid, and 4 moles of acetylacetone, 0.75 moles of TEOS and 0.25 moles of dimethyldiethoxysilane were added dropwise. To this mixture, 0.5 wt% of a nonionic surfactant (trade name S-386, SEIMI CHEMICAL Co., LTD.) was added, and stirred at 23 °C at 45% humidity for 2 hours, to obtain a SiO$_2$ sol-gel material solution. This sol-gel material solution was applied to a 100mm $\times$ 100mm $\times$ 0.7mm alkali-free glass substrate (trade name 0A10GF, NIPPON ELECTRIC GLASS, CO., LTD.) having a refractive index of 1.517 ($\lambda$ = 589 nm) by bar coating using a doctor blade (YOSHIMITSU SEIKI) in 40 $\mu$m film thickness. Sixty seconds after the application, the film mold produced above was pressed against and rolled along the obtained coating film, using a pressure roll heated to 80 °C. After the completion of the pressing, the film mold was peeled off, and the remaining glass substrate was sintered in an oven at 300 °C for 60 minutes. The glass substrate thus obtained had on its surface a concave-convex layer having the concave-convex pattern transferred from the surface profile of the film mold. The pressure roll had the roll diameter of 50 mm and the axial length of 350 mm, equipped with an internal heater, and circumferentially coated with 4 mm thick heat-resistant silicon.

An analysis image of a 10 $\mu$m square measurement region at a randomly selected location of the concavo-convex pattern of the concavo-convex layer was obtained using an atomic force microscope (trade name Nanonavi II station/E-sweep, scanning probe microscope with environmental control unit manufactured by HITACHI HIGH-TECHNOLOGIES CORPORATION). The analysis conditions of the atomic force microscope were as follows: Measurement mode: dynamic force mode; Cantilever: SI-DF40 (made of silicon, lever width: 40 $\mu$m, diameter of chip tip: 10 nm); Measuring atmosphere: atmospheric; Measuring temperature: 25 °C.

<Average Depth of Concavities and Convexities of Concavo-Convex Pattern>

In the analysis image, the distance in the depth direction between randomly selected concavities and convexities were measured at not less than 100 points, and the average was calculated. The result showed that the average depth of the concavities and convexities of the concavo-convex pattern was 70 nm.

<Fourier Transformed Image of Analysis Image of Concavo-convex Pattern>

An analysis image obtained in the same way as above was subjected to flatting treatment including primary tilt correction, and then to two-dimensional fast Fourier transform, to obtain a Fourier transformed image. It was confirmed that the Fourier transformed image represented a circular pattern approximately around the origin at which the absolute value of the wavenumber was 0 $\mu$m$^{-1}$, and the circular pattern was present in the region wherein the absolute value of the wavenumber was not more than 10 $\mu$m$^{-1}$.

<Average Pitch of Concavities and Convexities of Concavo-Convex Pattern>

A randomly selected 10 $\mu$m square region of the concavo-convex layer was measured to obtain an analysis image of the concavo-convex pattern in the same way as above. In this analysis image, the distance between randomly selected two adjacent convexities or between randomly selected two adjacent concavities was measured at not less than 100 points, and the average was calculated, which was taken as the average pitch of the concavo-convex pattern. The analysis image obtained in this example showed that the average pitch of the concavities and convexities of the concavo-convex pattern of the concavo-convex layer was 900 nm.

<Average Depth Distribution >

An analysis image of the concavo-convex pattern was obtained by measurement of a randomly selected 10 $\mu$m square region of the concavo-convex layer, and the depth data of the concavities and convexities were obtained at 128 points along the length by 128 points along the width, in total of not less than 16384 points, in the measurement region in the same way as above. The average (m) of the depth distribution of the concavities and convexities was obtained according to mathematical formula (I). The result showed that the average (m) of the depth distribution of the concavities and convexities of the concavo-convex layer was 70 nm.

$$m = \frac{1}{N}\sum_{i=1}^{N} x_i \qquad (\text{I})$$

In the formula (I), N is a total number of the measurement points (total number of pixels), $x_i$ is depth data of the concavity/convexity at the i-th measurement point, and m is an average of the depth distribution of the concavities and convexities.

<Depth Standard Deviation of Concavities and Convexities>

Depth data of the concavities and convexities in a 10 $\mu$m square region of the concavo-convex layer were obtained in the same way as in the determination of the average (m) of the depth distribution of the concavities and convexities. Here, the above-mentioned 256 points along the length by 256 points along the width, i.e., in total of 65536 measurement points were used. The standard deviation ($\sigma$) of the depth of the concavities and convexities were obtained according to mathematical formula (II) from the depth data of the concavities and convexities at the measurement points. The result showed that the standard deviation ($\sigma$) of the depth of the concavities and convexities of the concavo-convex layer was 48.1 nm.

$$\sigma = \sqrt{\frac{1}{N}\sum_{i=1}^{N}(x_i - m)^2} \qquad (\text{II})$$

In the formula (II), N is a total number of the measurement points (total number of pixels), $x_i$ is depth data of the concavity/convexity at the i-th measurement point, and m is an average of the depth distribution of the concavities and convexities.

<Formation of Light-emitting Part>

On the concavo-convex layer formed in the above, a film of ITO was formed by sputtering in a thickness of 120 nm, a photoresist was applied to form a mask pattern for a transparent electrode (first electrode layer), exposed the mask pattern, and developed with a developing solution. Then, the ITO was etched with an etching solution, to obtain a transparent electrode layer of the pattern as shown in Fig. 1 (1a). The transparent electrode layer thus obtained was brush-washed, cleaned with an alkaline detergent and an organic solvent for removing organic substances, and UV ozone treated.

On the transparent electrode layer thus obtained, a 35 nm thick hole transport layer of 4,4',4"-tris(9-carbazole)triphenylamine, a light-emitting layer composed of a 15 nm thick layer of 4,4',4"-tris(9-carbazole) triphenylamine doped with a tris (2-phenylpyridinato) iridium (III) complex and a 15 nm thick layer of 1,3,5-tris(N-phenylbenzimidazole-2-yl)benzene doped with a tris (2-phenylpyridinato) iridium (III) complex, and a 65 nm thick electron transport layer of 1,3,5-tris(N-phenylbenzimidazole-2-yl)benzene were laminated by vapor deposition, to obtain an organic luminescent layer. Then, a 1.5 nm thick lithium fluoride layer and a 50 nm thick aluminum metal electrode were vapor-deposited. In forming the organic luminescent layer and the metal electrode layer, patterning masks were used to form an organic luminescent layer and a metal electrode of particular shapes. Here, the light-emitting part of the organic luminescent layer was in a circular shape with the diameter D2 of 7.9 mm.

<Arrangement of Lens Member>

On the second surface of the glass substrate opposite to the first surface having the concavo-convex layer formed thereon, a semispherical lens (EDMUND OPTICS) having the diameter D1 of 10 mm and the refractive index of 1.517 ($\lambda$ = 589 nm) was aligned concentrically with the light-emitting part, and adhered thereto with a refractive liquid (SHIMADZU DEVICE CORPORATION) as an adhesive.

In the light-emitting element fabricated in the above-discussed procedure, the ratio r1 of the diameter D2 of the light-emitting part to the diameter D1 of the semispherical lens (D2/D1) was 0.79. The distance d in the Z direction from the center of the light-emitting part to the second surface of the glass substrate was substantially equal to the thickness of the glass substrate and was 0.7 mm. Accordingly, in the light-emitting element, the ratio r2 of the distance d to the diameter D1 of the semispherical lens (d/D1) was 0.07.

<Light-emitting area>

The light-emitting element was measured for the light-emitting area of the semispherical lens when the light-emitting part was caused to emit light, with respect to the light-emitting area being 100 % when the light emission was observed from the entire lens. The results are shown in Table 1 and Fig. 6(6a).

Comparative Example 1

A light-emitting element was produced in the same way as in Example 1, except that the semispherical lens was not provided, and the light-emitting area was measured. The results are shown in Table 1.

Example 2

A light-emitting element was produced in the same way as in Example 1, except that the diameter D2 of the light-emitting part was changed to 9.0 mm by changing the mask used in the patterning of the transparent electrode layer and the metal electrode layer. The r1 of the resulting light-emitting element was 0.90, and the r2 was 0.07. The light-emitting area was also measured in the same way as in Example 1. The results are shown in Table 1 and Fig. 6 (6b).

Comparative Example 2

A light-emitting element was produced in the same way as in Example 2, except that the semispherical lens was not provided, and the light-emitting area was measured. The results are shown in Table 1.

Comparative Example 3

A light-emitting element was produced in the same way as in Example 1, except that the diameter D2 of the light-emitting part was changed to 6.7 mm by changing the mask used in the patterning of the transparent electrode layer and the metal electrode layer. The r1 of the resulting light-emitting element was 0.67, and the r2 was 0.07. The light-emitting area was also measured in the same way as in Example 1. The results are shown in Table 1 and Fig. 6(6c).

Comparative Example 4

A light-emitting element was produced in the same way as in Example 1, except that the patterning masks used in the film formation of the organic luminescent layer and the metal electrode layer were changed to form an organic luminescent layer and a metal electrode layer in square shapes, and the light-emitting part was changed to a square shape of 5.9 mm along the length by 5.9 mm along the width. Here, the area of the light-emitting part was generally the same as that of the circular light-emitting part in Comparative Example 3. The obtained light-emitting element was measured for the light-emitting area in the same way as in Example 1. The results are shown in Table 1 and Fig. 6 (6d).

Table 1

|  | Lens | D1 (mm) | D2 (mm) | d (mm) | r1 (D2/D1) | r2 (d/D1) | Ratio of light-emitting area [3] (%) |
|---|---|---|---|---|---|---|---|
| Example 1 | present | 10 | 7.9 | 0.7 | 0.79 | 0.07 | 100.0 |
| Example 2 | present | 10 | 9.0 | 0.7 | 0.90 | 0.07 | 100.0 |
| Comp.Ex. 1 | absent | (10)[1] | 7.9 | 0.7 | 079 | 0.07 | 62.4 |
| Comp.Ex. 2 | absent | (10)[1] | 9.0 | 0.7 | 0.90 | 0.07 | 81.0 |
| Comp.Ex. 3 | present | 10 | 6.7 | 0.7 | 0.67 | 0.07 | 90.0 |
| Comp.Ex. 4 | present | 10 | *2 | 0.7 | - | 0.07 | 85.0 |

*1: For the sake of convenience in calculation of r1 and r2, D1 was set to the same 10 mm as in other Examples and Comparative Examples.

*2: Not indicated since the light-emitting part was in a square shape (5.9 mm square).

*3: Indicated as 100 % when light emission was observed from the entire lens of 100 mm in diameter (D1). In Comparative Examples 1 and 2, the values were calculated as if a lens of 10 mm in diameter was provided

Figs. 6(6a) to (6d) are schematic views illustrating the light emission of the light-emitting elements produced in Examples 1 and 2, and Comparative Examples 3 and 4, respectively, observed from the semispherical lens side, wherein the outermost circle in each figure indicates the circumference of the semispherical lens, and the circle inside the outermost circle, when entirely white, indicates the light-emitting area being 100 %. In Comparative Example 3, wherein an inner circle was observed inside the outermost circle, and in Comparative Example 4, wherein a rounded polygon was observed due to the square light emitting part, the black area between the inner circle or the inner rounded polygon and the outer circle indicated the region of the semispherical lens where the emitting light did not pass. In these cases, the light-emitting area was less than 100 %.

Table 1 and Fig. 6 show that the light-emitting area of the semispherical lens was 100 % in both Examples 1 and 2. On the other hand, in Comparative Examples 1 and 2 without the semispherical lens, the light-emitting areas were as low as 62.4 % and 81.0 %, respectively.

In Comparative Example 3, wherein r1 was below 0.7, the light-emitting area was 90 %, and in Comparative Example 4, wherein the light-emitting area was in a square shape, no emission was observed at the corners, and the light-emitting area was as low as 85%.

From the above-discussed results, it was confirmed that the light-emitting area of a lens may be extended by providing a concavo-convex layer and a circular semispherical lens with a light-emitting element, and setting the ratio r1 of the diameter D2 of the light-emitting part to the diameter D1 of the semispherical lens (D2/D1) to fall within the range of $0.7 < r1 \leq 1.0$.

The light-emitting element according to the present invention has sufficient light-emitting efficiency and a large light-emitting area, so that it is useful in various light-emitting devices, such as next-generation displays providing high contrast and suitable for thickness- and weight-saving, illumination devices, and luminescent display devices, such as taillights of vehicles, and contributes to energy saving. With the light-emitting element of the present invention, various devices, such as organic EL elements having excellent heat resistance, weatherability, and corrosion resistance, may be manufactured.

Explanation of Reference Signs

| 10, 20, 30, 40: | Light-emitting element |
| --- | --- |
| 11: | Translucent substrate |
| 12: | Concavo-convex layer |
| 13: | First electrode layer |
| 14: | Organic luminescent layer |
| 14a: | Light-emitting part |
| 15: | Second electrode layer |
| 16: | Lens member |

**Claims**

1. A light-emitting element comprising a translucent substrate having opposing first and second surfaces, a concavo-convex layer having on one of its surfaces a concavo-convex pattern, a first electrode, an organic luminescent layer having a light-emitting part, a second electrode, and a lens member having a diameter D1,
   wherein said concavo-convex layer, said first electrode layer, said organic luminescent layer, and said second electrode layer form a laminate in this order on a first surface side of said substrate, with said concavo-convex pattern arranged on a first electrode layer side of said concavo-convex layer,
   wherein said substrate is provided with said lens member on said second surface,
   wherein said light-emitting part is a laminated region of a diameter D2 of said organic luminescent layer held between said first and second electrode layers, and a center of said light-emitting part is aligned concentrically to a center of said lens member, and
   wherein a ratio of the diameter D2 of the light-emitting part to the diameter D1 of the lens member is $0.7 < D2/D1 \leq 1.0$.

2. The light-emitting element according to claim 1, wherein said concavo-convex layer is made of a sol-gel material.

3. The light-emitting element according to claim 1 or 2, wherein said laminate further comprises between the concavo-convex layer and the first electrode layer a covering layer covering the concavo-convex pattern.

4. The light-emitting element according to any one of claims 1 to 3, wherein said substrate is made of glass.

5. The light-emitting element according to any one of claims 1 to 4, wherein said lens member has a refractive index of not lower than 1.4.

6. The light-emitting element according to any one of claims 1 to 5, wherein in said concavo-convex pattern, an average pitch of concavities and convexities is 100 to 1500 nm, and a depth standard deviation of the concavities and convexities is 10 to 100 nm.

7. The light-emitting element according to any one of claims 1 to 6, wherein a Fourier transformed image of a plan shape of the concavo-convex pattern, obtained by processing a concavo-convex analysis image obtained using an atomic force microscope, by two-dimensional fast Fourier transform, represents a circular pattern approximately around an origin at which an absolute value of a wavenumber is 0 $\mu m^{-1}$, and said circular or an annular pattern is present in a region wherein an absolute value of a wavenumber is not more than 10 $\mu m^{-1}$.

8. The light-emitting element according to any one of claims 1 to 7, wherein said diameter D1 is 1 to 100 mm.

9. The light-emitting element according to any one of claims 1 to 8, wherein said diameter D2 is 0.7 to 100 mm.

10. The light-emitting element according to any one of claims 1 to 9, wherein a distance d from a center of the light-emitting part to the second surface of the substrate is 0.04 to 5 mm.

Fig. 1

Fig. 2

**Fig. 3**

**Fig. 4**

**Fig. 5**

(6a)

(6b)

(6c)

(6d)

**Fig. 6**

<table>
<tr><td colspan="2" align="center">**INTERNATIONAL SEARCH REPORT**</td><td colspan="2">International application No.<br>PCT/JP2015/062507</td></tr>
</table>

**A. CLASSIFICATION OF SUBJECT MATTER**
*H05B33/02*(2006.01)i, *G02B3/00*(2006.01)i, *G02B5/18*(2006.01)i, *H01L51/50* (2006.01)i, *H05B33/22*(2006.01)i

According to International Patent Classification (IPC) or to both national classification and IPC

**B. FIELDS SEARCHED**

Minimum documentation searched (classification system followed by classification symbols)
H05B33/02, G02B3/00, G02B5/18, H01L51/50, H05B33/22

Documentation searched other than minimum documentation to the extent that such documents are included in the fields searched
Jitsuyo Shinan Koho     1922–1996    Jitsuyo Shinan Toroku Koho    1996–2015
Kokai Jitsuyo Shinan Koho    1971–2015    Toroku Jitsuyo Shinan Koho    1994–2015

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2013/73434 A1 (JX Nippon Oil & Energy Corp.),<br>23 May 2013 (23.05.2013),<br>paragraphs [0042], [0159], [0212], [0225], [0285] to [0286]<br>& JP 2013-109932 A     & JP 2013-127844 A<br>& US 2014/0306213 A1    & EP 2782155 A1<br>& CA 2856007 A      & CN 103947000 A<br>& AU 2012338004 A    & KR 10-2014-0092810 A<br>& TW 201334252 A | 1–10 |

☒ Further documents are listed in the continuation of Box C.     ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>15 June 2015 (15.06.15) | Date of mailing of the international search report<br>23 June 2015 (23.06.15) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (July 2009)

**INTERNATIONAL SEARCH REPORT**

| International application No. |
| --- |
| PCT/JP2015/062507 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | JP 2012-109230 A  (Semiconductor Energy Laboratory Co., Ltd.), 07 June 2012 (07.06.2012), claim 2; paragraphs [0013], [0038], [0068] to [0069]; fig. 3 & US 2012/0097991 A1    & WO 2012/053571 A1 & DE 112011103543 T    & TW 201246642 A | 1-10 |
| Y | JP 2012-49113 A  (Semiconductor Energy Laboratory Co., Ltd.), 08 March 2012 (08.03.2012), claim 4; paragraphs [0020], [0025]; fig. 1 & US 2012/0020085 A1    & US 2013/0265762 A1 & WO 2012/014758 A1    & TW 201300679 A & KR 10-2013-0046434 A | 1-10 |
| Y A | WO 2013/187149 A1  (JX Nippon Oil & Energy Corp.), 19 December 2013 (19.12.2013), paragraphs [0019], [0043]; fig. 1 & JP 5680800 B         & US 2015/0060840 A1 & AU 2013275607 A      & CA 2874212 A & KR 10-2014-0141679 A  & CN 104380843 A & TW 201407848 A | 3-7,10 1-2,8-9 |
| Y A | JP 2011-65773 A  (Fujifilm Corp.), 31 March 2011 (31.03.2011), paragraphs [0038], [0051] to [0052]; fig. 3 (Family: none) | 5-7,10 1-4,8-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 201 A
- JP 2013127844 A
- WO 2012096368 A
- WO 2013161454 A
- WO 2011007878 A1
- JP H08112879 A

- JP H05238827 A
- JP H06122852 A
- JP H06240208 A
- JP H06299118 A
- JP H06306329 A
- JP H07196986 A